# EUROPÄISCHE PATENTSCHRIFT

(11) **EP 2 580 471 B1**
(45) Veröffentlichungstag und Bekanntmachung des Hinweises auf die Patenterteilung: **21.10.2015**
(21) Anmeldenummer: 11725402.9
(22) Anmeldetag: 03.06.2011
(51) Int. Cl.: F03D 7/04, G01R 31/327, F01D 21/20

(54) **WINDENERGIEANLAGE UND VERFAHREN ZUM PRÜFEN EINES DREHZAHLRELAIS EINER WINDENERGIEANLAGE**
WIND TURBINE AND METHOD FOR CHECKING A ROTATIONAL SPEED RELAY OF A WIND TURBINE
ÉOLIENNE ET PROCÉDÉ POUR VÉRIFIER UN RELAIS DE VITESSE DE ROTATION D'UNE ÉOLIENNE

(30) Priorität: 22.06.2010 DE 102010024566; 10.06.2010 DE 102010023279
(43) Veröffentlichungstag der Anmeldung: 17.04.2013
(73) Patentinhaber: Senvion GmbH, 22297 Hamburg (DE)
(72) Erfinder: BOLLN, Sönke, 25746 Heide (DE)
(74) Vertreter: Glawe, Delfs, Moll
(86) Internationale Anmeldenummer: PCT/EP2011/059193
(87) Internationale Veröffentlichungsnummer: WO 2011/154318

(56) Entgegenhaltungen:
- US-A- 4 217 617
- US-A1- 2008 101 918
- US-A1- 2009 193 894
- US-A1- 2009 295 161

## Beschreibung

Die Erfindung betrifft ein Verfahren zum Prüfen eines Drehzahlrelais einer Windenergieanlage. Die Windenergieanlage umfasst einen Drehzahlsensor für die Drehzahl einer Welle. Der Drehzahlsensor gibt ein Drehzahlsignal aus, das einem Signaleingang des Drehzahlrelais zugeführt wird. Das Drehzahlrelais erzeugt einen Abschaltbefehl, wenn die Drehzahl der Welle einen vorgegebenen Drehzahlgrenzwert überschreitet. Die Erfindung betrifft außerdem eine Windenergieanlage zum Durchführen des Verfahrens.

Die Drehzahl, mit der der Rotor einer Windenergieanlage sich dreht, ist ein sicherheitsrelevanter Parameter. Wenn die Drehzahl sich aus dem vorgesehenen Drehzahlband herausbewegt, kann die Windenergieanlage Schaden nehmen. Die Steuerung der Windenergieanlage ist so eingerichtet, dass die betreffenden Drehzahlgrenzen im normalen Betrieb nicht überschritten werden. Treten allerdings Fehler in der Windenergieanlage auf, wie beispielsweise ein Defekt der Steuerung oder ein fehlerhaftes Signal von einem Sensor, kann es passieren, dass die Windenergieanlage nicht mehr wie vorgesehen arbeitet und dass die Drehzahlgrenzen überschritten werden.

Das Dokument US-A-2009/0193894 offenbart eine Windenergieanlage, die als nächstliegender Stand der Technik angesehen wird.

Für diesen Fall ist ein zusätzlicher Sicherheitsmechanismus vorgesehen. Mit einem Drehzahlrelais wird die Drehzahl laufend überwacht und bei Überschreiten eines Drehzahlgrenzwerts ein Abschaltbefehl erzeugt. Der Abschaltbefehl, der Vorrang vor den Befehlen der normalen Steuerung hat, bewirkt, dass die Windenergieanlage so schnell wie möglich außer Betrieb gesetzt wird.

Das Drehzahlrelais wird in regelmäßigen Wartungsintervallen auf ordnungsgemäße Funktion überprüft. Bislang ist dafür das folgende Verfahren vorgesehen. Ein Servicetechniker fährt zu der Windenergieanlage und bringt diese zum Stillstand. Das Drehzahlrelais wird umprogrammiert auf einen neuen Drehzahlgrenzwert, der im normalen Betrieb überschritten werden kann. Anschließend setzt der Servicetechniker die Windenergieanlage in Gang, so dass der nun neu gesetzte niedrigere Drehzahlgrenzwert überschritten wird. Der Servicetechniker prüft, ob das Drehzahlrelais ordnungsgemäß einen Abschaltbefehl gibt. Verläuft die Prüfung positiv, wird die Windenergieanlage wieder angehalten, das Drehzahlrelais auf den ursprünglichen Drehzahlgrenzwert zurück programmiert und die Windenergieanlage wieder in der normalen Betrieb versetzt. Dieser Vorgang ist fehleranfällig. Unter anderem ist es denkbar, dass das Drehzahlrelais am Ende nicht auf den ursprünglichen, sondern auf einen falschen Grenzwert programmiert wird.

Der Erfindung liegt ausgehend von dem eingangs genannten Stand der Technik die Aufgabe zu Grunde, eine Windenergieanlage und ein Verfahren vorzustellen, mit denen das Drehzahlrelais kostengünstig und zuverlässig überprüft werden kann. Die Aufgabe wird gelöst durch die Merkmale der unabhängigen Ansprüche. Vorteilhafte Ausführungsformen finden sich in den Unteransprüchen.

Zunächst werden einige Begriffe erläutert. Eine Welle im Sinne der Erfindung ist jedes Element des mechanischen Triebstrangs, dessen Drehzahl in einem festen Verhältnis zur Drehzahl des Rotors steht. Vom Begriff Welle umfasst sind beispielsweise die Rotorwelle sowie drehende Komponenten von Getriebe und Generator. Aus der Drehzahl der Welle kann unmittelbar die Drehzahl des Rotors abgeleitet werden. Das Drehzahlsignal repräsentiert die Drehzahl der Welle.

Der Drehzahlgrenzwert begrenzt das Drehzahlband, innerhalb dessen sich die Windenergieanlage im normalen Betrieb bewegt. Der Drehzahlgrenzwert kann das Drehzahlband nach oben oder nach unten begrenzen. Sowohl eine Überschreitung des oberen Grenzwerts nach oben als auch eine Überschreitung des unteren Grenzwerts nach unten wird als Überschreitung des Drehzahlgrenzwerts angesehen.

Der Abschaltbefehl kann als elektrisches Signal an eine Komponente der Windenergieanlage übermittelt werden, die das Abschalten der Windenergieanlage übernimmt. Die Übermittlung des Abschaltbefehls kann auch darin bestehen, dass die Sicherheitskette der Windenergieanlage geöffnet wird. Die Sicherheitskette bezeichnet eine Leitung, über die mehrere sicherheitsrelevante Elemente der Windenergieanlage miteinander gekoppelt sind. Wenn in einem der Elemente ein Fehler auftritt wird, die Sicherheitskette geöffnet, was zur Folge hat, dass die Windenergieanlage zum Stillstand gebracht wird.

Bei dem erfindungsgemäßen Verfahren wird zunächst das Drehzahlsignal inaktiviert, so dass das Drehzahlrelais kein Signal mehr von dem Drehzahlsensor erhält. Dies kann beispielsweise dadurch geschehen, dass eine entsprechende Kabelverbindung unterbrochen wird. Möglich ist es auch, die Windenergieanlage zum Stillstand zu bringen, so dass der Drehzahlsensor aus diesem Grund kein Signal mehr liefert. Ferner wird ein Signalgenerator aktiviert, der ein zu dem Drehzahlsignal äquivalentes Prüfsignal erzeugt. Ein Prüfsignal ist dann äquivalent zu einem Drehzahlsignal, wenn das Drehzahlrelais dem Prüfsignal eine Drehzahlinformation entnehmen kann. Der Signalgenerator wird so betrieben, dass er ein jenseits des Drehzahlgrenzwerts liegendes Prüfsignal erzeugt. Das Drehzahlrelais entnimmt dem Prüfsignal also die Information, dass der Drehzahlgrenzwert überschritten ist. Mit dem Überschreiten des Grenzwerts muss ein ordnungsgemäß funktionierendes Drehzahlrelais einen Abschaltbefehl geben. Es wird geprüft, ob dieser Abschaltbefehl tatsächlich gegeben wird.

Indem dem Drehzahlrelais mit einem synthetischen Prüfsignal bestimmte Drehzahlen vorgespielt werden, kann die Reaktion des Drehzahlrelais getestet werden, ohne dass die Welle tatsächlich diese Drehzahl hat. Insbesondere wird es damit möglich, Überprüfungen außerhalb des normalen Drehzahlbereichs durchzuführen. Es entfällt das fehleranfällige Umprogrammieren des Drehzahlrelais, das anderenfalls erforderlich ist, um im normalen Drehzahlbereich Grenzwertüberschreitungen simulieren zu können.

Mit Vorteil kann das Verfahren so durchgeführt werden, dass der Signalgenerator zunächst mit einem Prüfsignal betrieben wird, das innerhalb des normalen Drehzahlbands liegt, mit dem also kein Drehzahlgrenzwert überschritten ist. Anschließend kann das Prüfsignal so verändert werden, dass der Drehzahlgrenzwert überschritten wird. Auf diese Weise kann zuverlässig überprüft werden, ob das Drehzahlrelais zum richtigen Zeitpunkt auslöst.

Das Verfahren kann wie dargelegt in der Weise durchgeführt werden, dass ein Servicetechniker vor Ort die Windenergieanlage zum Stillstand bringt und anstelle des Drehzahlsensors einen Signalgenerator an das Drehzahlrelais anschließt. Alternativ kann auch vorgesehen sein, dass automatisch zwischen dem Drehzahlsignal vom Drehzahlsensor und dem Prüfsignal vom Signalgenerator umgeschaltet wird. Dadurch wird es möglich, das Drehzahlrelais in Fernwartung zu überprüfen. Gegebenenfalls kann die Windenergieanlage während der Überprüfung in Betrieb bleiben, sofern auf alternative Sensoren in der Windenergieanlage zurückgegriffen werden kann.

Häufig umfasst eine Windenergieanlage eine Mehrzahl von Drehzahlsensoren, mit denen die Drehzahl der Rotorwelle und/oder von mit der Rotorwelle gekoppelten Wellen erfasst wird. Beispielsweise können an der Rotorwelle, die zugleich die Eingangswelle des Getriebes ist, zwei redundante Drehzahlsensoren angeordnet sein. An der Generatorwelle als Ausgangswelle des Getriebes kann sich ein weiterer Drehzahlsensor befinden. Das Drehzahlrelais kann so ausgelegt sein, dass es über eine Mehrzahl von Signaleingängen die Drehzahlsignale von mehreren Drehzahlsensoren empfängt. Ein Abschaltbefehl wird vorzugsweise bereits dann erzeugt, wenn nur einer der Drehzahlsensoren eine Überschreitung des Drehzahlgrenzwerts meldet. Indem das Prüfsignal des Signalgenerators nacheinander an die verschiedenen Signaleingänge angelegt wird, kann das ordnungsgemäße Funktionieren mehrerer Signaleingänge überprüft werden. Alternativ können mehrere Drehzahlrelais vorgesehen sein, wobei vorzugsweise jedem Drehzahlsensor ein Drehzahlrelais zugeordnet ist. Die Mehrzahl von Drehzahlrelais kann nacheinander oder parallel getestet werden.

Wenn mehrere Drehzahlsensoren vorhanden sind, kann im Rahmen des erfindungsgemäßen Verfahrens außerdem die ordnungsgemäße Funktionsweise dieser Sensoren überprüft werden. Dazu werden bei drehender Welle die Drehzahlsignale der verschiedenen Drehzahlsensoren miteinander verglichen. Bei ordnungsgemäßer Funktion müssten alle Drehzahlsignale dieselbe Drehzahlinformation liefern, eine Abweichung zwischen den Drehzahlinformationen deutet auf einen Fehler hin. Liegt ein Drehzahlsensor an einer schnellen Welle und ein Drehzahlsensor an einer langsamen Welle, wobei die Drehzahlen der Wellen in einem festen Verhältnis stehen, so müssen die Drehzahlsignale entsprechend umgerechnet werden, bevor ein Vergleich möglich ist. Dies gilt beispielsweise für Drehzahlsensoren an der langsamen Rotorwelle und der schnellen Generatorwelle, die über das Getriebe in einem festen Verhältnis miteinander gekoppelt sind. Ggf. kann zusätzlich überprüft werden, ob identische Drehzahlsignale von verschiedenen Komponenten als dieselbe Drehzahl interpretiert werden. Die verschiedenen Komponenten können beispielsweise zwei Drehzahlrelais sein oder ein Drehzahlrelais und die Steuerung der Windenergieanlage. Mit dieser Überprüfung können weitere mögliche Fehler in der Windenergieanlage entdeckt werden. Alternativ kann geprüft werden, ob Drehzahlsignale, die in einem bekannten Verhältnis zueinander stehen, von den Komponenten richtig interpretiert werden.

Die Erfindung betrifft außerdem eine Windenergieanlage, die dazu ausgelegt ist, das Verfahren automatisch durchzuführen. Die Windenergieanlage umfasst einen Drehzahlsensor, mit dem die Drehzahl einer Welle erfasst werden kann. Außerdem umfasst die Windenergieanlage ein Drehzahlrelais mit einem Signaleingang, an den ein Drehzahlsignal von dem Drehzahlsensor angelegt werden kann. Das Drehzahlrelais ist dazu ausgelegt, einen Abschaltbefehl zu erzeugen, sobald das Drehzahlsignal einen vorgegebenen Drehzahlgrenzwert überschreitet. Ferner ist ein Signalgenerator vorgesehen, um ein zu dem Drehzahlsignal äquivalentes Prüfsignal zu erzeugen. Mit einem Umschaltmodul kann am Signaleingang des Drehzahlrelais zwischen dem Drehzahlsignal und dem Prüfsignal umgeschaltet werden. Schließlich umfasst die Windenergieanlage ein Kontrollmodul, das den Signalgenerator und das Umschaltmodul steuert. Das Kontrollmodul weist das Umschaltmodul an, das Prüfsignal an den Signaleingang zu legen, und gibt dem Signalgenerator den Befehl, ein jenseits des Drehzahlgrenzwerts liegendes Prüfsignal zu erzeugen. Anschließend prüft das Kontrollmodul, ob das Drehzahlrelais einen Abschaltbefehl erzeugt.

Das Drehzahlrelais kann eine Mehrzahl von Signaleingängen aufweisen und das Umschaltmodul kann dazu ausgelegt sein, an jedem der Signaleingänge zwischen dem Drehzahlsignal und dem Prüfsignal umzuschalten. Dadurch kann das erfindungsgemäße Verfahren auch dann automatisch durchgeführt werden, wenn die Windenergieanlage mehrere Drehzahlsensoren aufweist, deren Drehzahlsignale dem Drehzahlrelais zugeführt werden. Die Windenergieanlage kann ferner ein Vergleichsmodul aufweisen, um die Drehzahlsignale der Mehrzahl von Drehzahlsensoren zu vergleichen. Liegt zwischen zwei Drehzahlsensoren ein Getriebe, muss das Drehzahlsignal entsprechend umgerechnet werden, damit ein Vergleich möglich wird.

Die Windenergieanlage kann mit weiteren Merkmalen kombiniert werden, die oben mit Bezug auf das erfindungsgemäße Verfahren beschrieben sind.

Die Erfindung wird nachfolgend unter Bezugnahme auf die beigefügten Zeichnungen anhand einer vorteilhaften Ausführungsform beispielhaft beschrieben. Es zeigen:
- Fig. 1:: eine schematische Darstellung einer Windenergieanlage;
- Fig. 2:: eine vergrößerte Darstellung von Komponenten der Windenergieanlage aus Fig. 1;
- Fig. 3:: eine schematische Darstellung eines Drehzahlsignals;
- Fig. 4:: eine schematische Darstellung eines Drehzahlrelais mit einem daran angeschlossenen Signalgenerator;
- Fig. 5:: eine schematische Ansicht einer erfindungsgemäßen Windenergieanlage; und
- Fig. 6:: ein Ablaufdiagramm des erfindungsgemäßen Verfahrens.

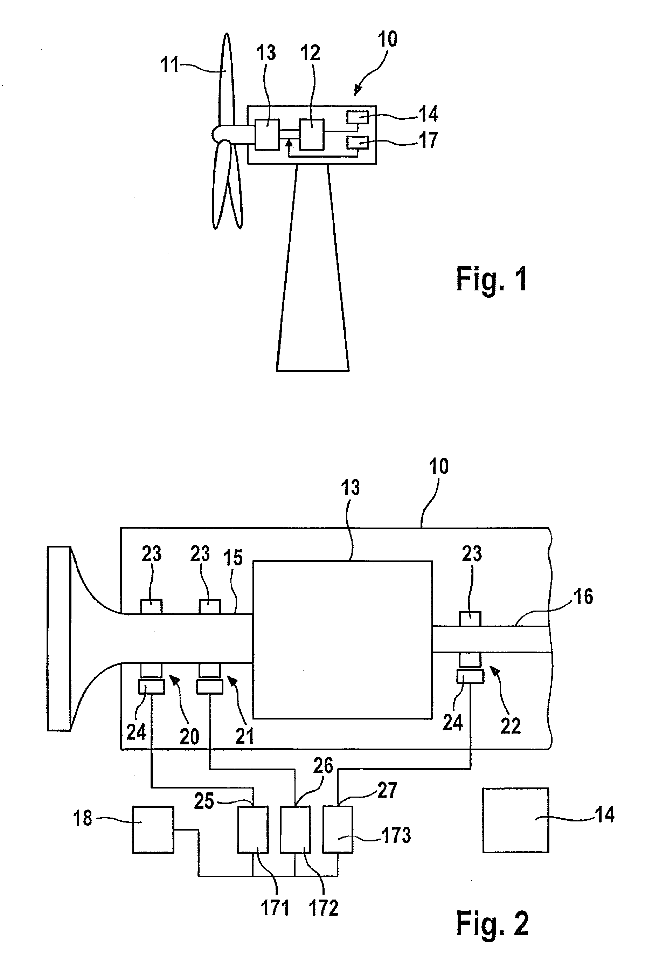

Bei einer in Fig. 1 gezeigten Windenergieanlage 10 treibt ein Rotor 11 einen Generator 12 an. Mit dem Generator 12 wird die Rotationsenergie in elektrische Energie umgewandelt. Die elektrische Energie wird in ein nicht dargestelltes Stromnetz eingespeist. Eine Steuerung 14 der Windenergieanlage 10 steuert das Zusammenspiel der Komponenten der Windenergieanlage 10. Unter anderem sorgt die Steuerung 14 dafür, dass im normalen Betrieb der Windenergieanlage 10 ein bestimmter vorgegebener Drehzahlgrenzwert n_{grenz} nicht überschritten wird.

Die Windenergieanlage 10 umfasst ein Getriebe 13, mit dem die langsame Drehung einer Rotorwelle 15 auf eine höhere Drehzahl übersetzt und an eine Generatorwelle 16 wieder abgegeben wird. Mit der Generatorwelle 16 wird der Generator 12 angetrieben. Zwar ist die Windenergieanlage 10 so ausgelegt, dass ein durch Drehzahlgrenzwerte n_{grenz} begrenztes Drehzahlband im normalen Betrieb nicht verlassen wird. Nicht ausgeschlossen ist aber, dass einer der Drehzahlgrenzwerte n_{grenz} in außergewöhnlichen Situationen, wie beispielsweise einem Fehler in der Steuerung 14 doch überschritten werden kann. Die Windenergieanlage 10 umfasst deswegen ein Drehzahlrelais 17, das bei einer Überschreitung des Drehzahlgrenzwerts n_{grenz} eingreift und dafür sorgt, dass die Windenergieanlage 10 kontrolliert zum Stillstand gebracht wird. Sobald das Drehzahlrelais 17 eine Drehzahlüberschreitung feststellt, gibt es einen Abschaltbefehl an ein Abschaltmodul 18. Das Abschaltmodul 18 führt eine Notabschaltung der Windenergieanlage 10 durch, mit der die Windenergieanlage 10 schnell zum Stillstand gebracht wird. Dazu werden die Rotorblätter des Rotors 11 so eingestellt, dass sie keine kritische Energie mehr aus dem Wind aufnehmen, sondern den Rotor 11 abbremsen. Um die Windenergieanlage 10 vollständig zum Stillstand zu bringen, kann zusätzlich eine auf den Rotor 11 wirkende Bremse angezogen werden (z.B. im Fall einer Unterdrehzahl).

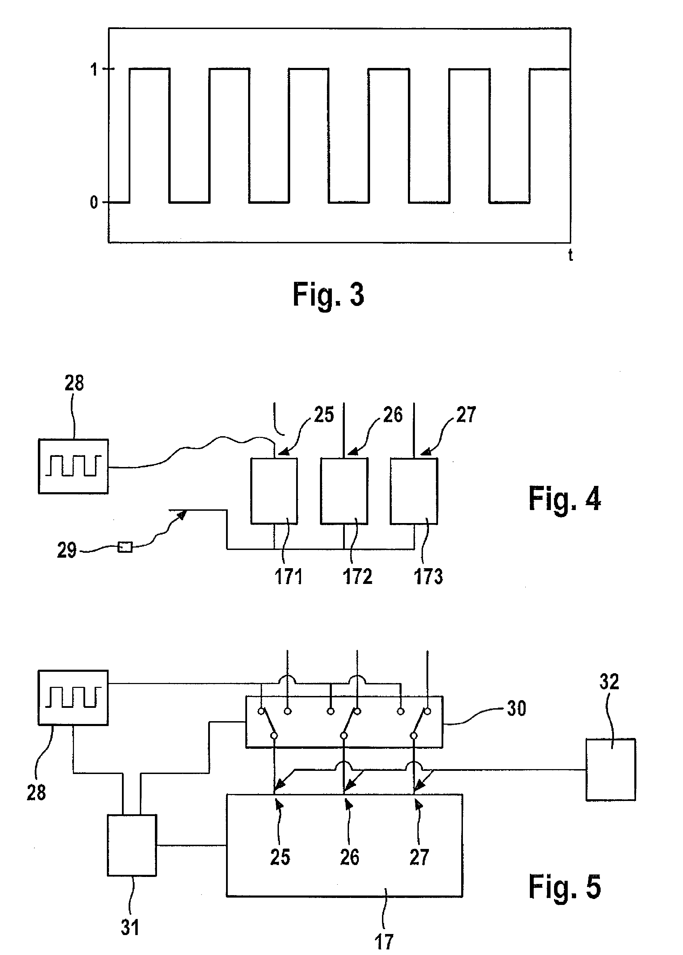

In Fig. 2 umfasst die Windenergieanlage 10 drei Drehzahlrelais 171, 172, 173, denen über drei Signaleingänge 25, 26, 27 Informationen über die Drehzahl der Rotorwelle 15 und der Generatorwelle 16 zugeführt werden. Für die Erzeugung des Drehzahlsignals sind auf der Rotorwelle zwei Drehzahlsensoren 20, 21 und auf der Generatorwelle ein Drehzahlsensor 22 ausgebildet. Die doppelte Auslegung der Drehzahlsensoren 20, 21 auf der Rotorwelle 15 dient der Redundanz und der Drehrichtungserkennung. Jeder der Drehzahlsensoren 20, 21, 22 umfasst eine Zahnscheibe 23 und einen induktiven oder optischen Messfühler 24. Die Zahnscheiben 23 drehen sich mit der Rotorwelle 15 bzw. der Generatorwelle 16, so dass an den Messfühlern 24 abwechselnd ein Zahn bzw. eine Zahnlücke anliegt. Die Messfühler 24 nehmen diese Information auf und erzeugen daraus ein Rechtecksignal, wie es beispielhaft in Fig. 3 dargestellt ist. Die Rechtecksignale werden den Signaleingängen 25, 26, 27 der Drehzahlrelais 171, 172, 173 zugeführt. In den Drehzahlrelais 171, 172, 173 wird das Rechtecksignal ausgewertet und anhand der Frequenz des Rechtecksignals ermittelt, wie schnell die zugehörige Welle sich dreht.

Die aus den Rechtecksignalen ermittelte Drehzahl wird laufend mit dem Drehzahlgrenzwert n_{grenz} verglichen, wobei für das Rechtecksignal von der schnell drehenden Rotorwelle 16 ein entsprechend höherer Drehzahlgrenzwert gilt als für die langsam drehende Rotorwelle 15. Wird an einem der Signaleingänge 25, 26, 27 eine Überschreitung des Drehzahlgrenzwerts n_{grenz} festgestellt, übermittelt das zugehörige Drehzahlrelais 171, 172, 173 einen Abschaltbefehl an ein Abschaltmodul 18. Das Abschaltmodul 18 übernimmt die Kontrolle über die Windenergieanlage 10 und führt eine Schnellabschaltung der Windenergieanlage 10 durch. Das Abschaltmodul 18 ist vorzugsweise in der Nabe der Windenergieanlage 10 angeordnet. Befehle von dem Abschaltmodul 18 haben dann Vorrang vor Befehlen von der Steuerung 14.

Die ordnungsgemäße Funktion der Drehzahlrelais 171, 172, 173 wird in bestimmten Wartungsintervallen überprüft. Bei einer in Fig. 4 dargestellten Ausführungsform wird das erfindungsgemäße Verfahren durch einen Servicetechniker vor Ort durchgeführt. Der Servicetechniker trennt eine Verbindungsleitung zwischen einem der Drehzahlsensoren 20, 21, 22 und dem zugehörigen Signaleingang 25, 26, 27 und inaktiviert damit das dem Drehzahlrelais 171, 172, 173 zugeführte Drehzahlsignal. In Fig. 4 ist dies am Beispiel des Signaleingangs 25 dargestellt. Anstatt des Drehzahlsensors 20 wird ein Signalgenerator 28 an den Signaleingang 25 angeschlossen, der ein Rechtecksignal und damit ein zu dem Drehzahlsignal äquivalentes Prüfsignal erzeugt. Der Signalgenerator 28 wird zunächst so betrieben, dass das Prüfsignal einer Drehzahl entspricht, die kleiner als ein oberer Drehzahlgrenzwert n_{grenz} ist. Der Servicetechniker erhöht die Frequenz des Drehzahlsignals, bis das Prüfsignal schließlich einer Drehzahl entspricht, die oberhalb des Drehzahlgrenzwerts n_{grenz} liegt. Zum Testen eines unteren Drehzahlgrenzwert wird das Verfahren entsprechend mit Absenken der Frequenz angewendet. Ein ordnungsgemäß funktionierendes Drehzahlrelais 171, 172, 173 erzeugt mit dem Überschreiten des Drehzahlgrenzwerts n_{grenz} einen Abschaltbefehl. Mit einem Messgerät 29 überprüft der Servicetechniker, ob das Abschaltbefehl korrekt erzeugt wird. Gegebenenfalls kann der Abschaltbefehl auch anhand einer entsprechenden Kontrollleuchte am Drehzahlrelais 171, 172, 173 oder anhand einer in der Steuerung 14 eingehenden Fehlermeldung geprüft werden. Wird der Abschaltbefehl korrekt erzeugt, wird der Signalgenerator 28 von dem Signaleingang 25 getrennt und stattdessen wieder der Drehzahlsensor 20 angeschlossen. Stellt der Servicetechniker einen Fehler in einem der Drehzahlrelais 171, 172, 173 fest, so muss das entsprechende Drehzahlrelais repariert oder ausgetauscht werden. In einfachen Fällen kann es ausreichen, wenn das Drehzahlrelais neu parametriert wird.

Nachdem das Verfahren bei dem Signaleingang 25 und dem Drehzahlrelais 171 abgeschlossen ist, wird es anschließend in gleicher Weise bei den Signaleingängen 26, 27 und den Drehzahlrelais 172, 173 durchgeführt. Bei dem Signaleingang 27, der für die schnelle Generatorwelle 16 zuständig ist, muss das Prüfsignal eine entsprechend höhere Frequenz haben, um eine Überschreitung des Drehzahlgrenzwerts n_{grenz} zu simulieren. Führt die Überprüfung bei allen drei Signaleingängen 25, 26, 27 und allen Drehzahlrelais 171, 172, 173 zu dem Ergebnis, dass der Abschaltbefehl korrekt erzeugt wird, ist die Prüfung erfolgreich abgeschlossen und die Windenergieanlage 10 kann wieder normal in Betrieb gesetzt werden.

Bei einer in Fig. 5 gezeigten alternativen Ausführungsform umfasst die Windenergieanlage 10 ein einzelnes Drehzahlrelais 17 mit drei Signaleingängen 25, 26, 27. Die Windenergieanlage 10 ist in diesem Beispiel so eingerichtet, dass das Verfahren automatisch durchgeführt werden kann. Der Signalgenerator 28 ist dazu fest in der Windenergieanlage 10 installiert und es ist ein Umschaltmodul 30 vorgesehen, um anstatt des Drehzahlsignals ein Prüfsignal von dem Signalgenerator 28 an die Signaleingänge 25, 26, 27 zu legen. Das Verfahren wird auf die gleiche Weise durchgeführt, wie mit Bezug auf Fig. 4 beschrieben, wobei ein Kontrollmodul 31 den Signalgenerator 28 und das Umschaltmodul 30 so steuert, dass sie die Schritte des erfindungsgemäßen Verfahrens durchführen. Das Kontrollmodul 31 prüft außerdem, ob jeweils zum richtigen Zeitpunkt ein Abschaltbefehl von dem Drehzahlrelais 17 erzeugt wird.

Gemäß Fig. 5 umfasst die Windenergieanlage 10 außerdem ein Vergleichsmodul 32. Das Vergleichsmodul 32 greift an den Signaleingängen 25, 26, 27 des Drehzahlrelais 17 die Drehzahlsignale von den Drehzahlsensoren 20, 21, 22 ab und vergleicht diese miteinander. Das Drehzahlsignal von der schnellen Generatorwelle 16, das am Signaleingang 27 anliegt, wird entsprechend dem Übersetzungsverhältnis des Getriebes 13 umgerechnet, so dass ein direkter Vergleich mit den Drehzahlsignalen von der Rotorwelle 15 möglich ist. Führt der Vergleich zu dem Ergebnis, dass an allen drei Signaleingängen 25, 26, 27 die gleiche Drehzahlinformation ankommt, deutet dies daraufhin, dass die Drehzahlsensoren 20, 21, 22 ordnungsgemäß funktionieren.

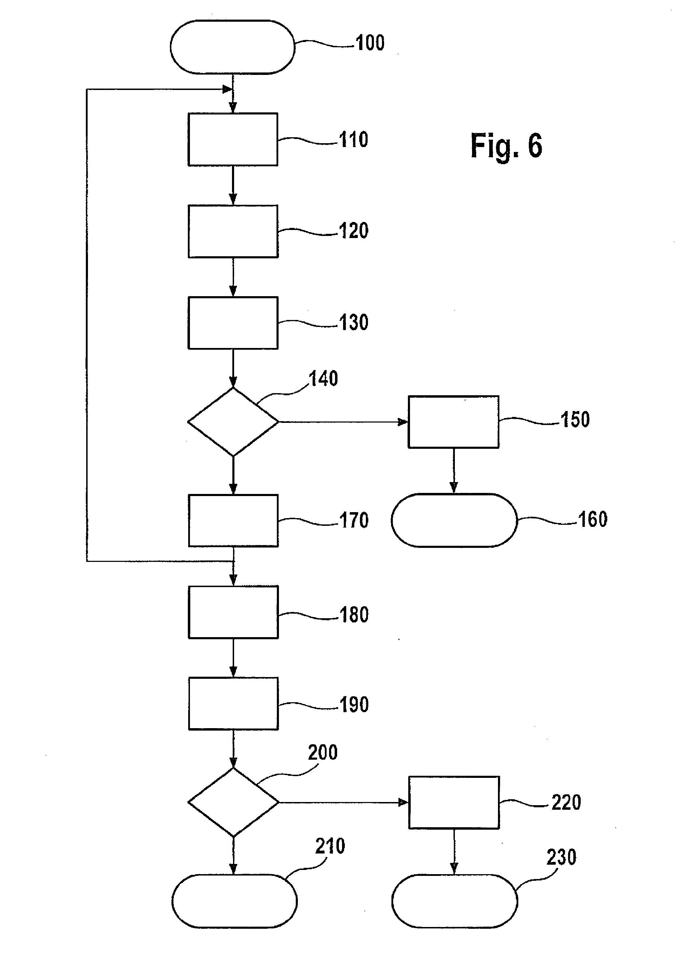

In Fig. 6 ist das erfindungsgemäße Verfahren in Form eines Ablaufdiagramms dargestellt. Nach dem Start des Verfahrens bei 100 wird in Schritt 110 an einem der Signaleingänge 25, 26, 27 die Verbindung zu dem zugehörigen Drehzahlsensor 20, 21, 22 getrennt und damit das Drehzahlsignal für diesen Signaleingang inaktiviert. Nachdem in Schritt 120 der Signalgenerator 28 an den betreffenden Signaleingang angeschlossen wurde, wird in Schritt 130 das Prüfsignal von einem diesseits des Drehzahlgrenzwerts n_{grenz} liegenden Wert erhöht, bis der Drehzahlgrenzwert n_{grenz} überschritten wird. Führt die die Überprüfung in Schritt 140 zu dem Ergebnis, dass das Drehzahlrelais keinen ordnungsgemäßen Abschaltbefehl erzeugt hat, wird bei 150 festgestellt, dass das Drehzahlrelais 17 fehlerhaft ist, und das Verfahren mit Schritt 160 abgeschlossen.

Führt die Abfrage in Schritt 140 zu dem Ergebnis, dass der Abschaltbefehl korrekt erzeugt wird, wird bei 170 der Signalgenerator von dem Signaleingang getrennt und wieder eine Verbindung zu dem zugehörigen Drehzahlsensor hergestellt. Anschließend wird das Verfahren bei den anderen Signaleingängen in gleicher Weise durchgeführt.

In Schritt 180 wird bei drehendem Rotor 11 das Drehzahlsignal an den Signaleingängen 25, 26, 27 abgegriffen. Das Drehzahlsignal an dem Signaleingang 27 wird entsprechend dem Übersetzungsverhältnis des Getriebes 13 umgerechnet, so dass ein direkter Vergleich mit dem Drehzahlsignal an den Signaleingängen 25, 26 möglich ist. Führt die Abfrage in Schritt 200 zu dem Ergebnis, dass die Drehzahlsignale übereinstimmen, ist die Überprüfung erfolgreich verlaufen und das Verfahren wird bei 210 abgeschlossen. Wird in Schritt 200 eine Abweichung zwischen den Drehzahlsignalen festgestellt, wird in Schritt 220 eine Fehlermeldung ausgegeben, und die Drehzahlsensoren 20, 21, 22 müssen überprüft werden.

## Patentansprüche

1. Verfahren zum Prüfen eines Drehzahlrelais (17) einer Windenergieanlage (10), bei dem die Windenergieanlage (10) einen Drehzahlsensor (20, 21, 22) für die Drehzahl einer Welle (15, 16) umfasst, bei dem der Drehzahlsensor (20, 21, 22) ein Drehzahlsignal ausgibt, bei dem das Drehzahlsignal einem Signaleingang (25, 26, 27) des Drehzahlrelais (17) zugeführt wird und bei dem das Drehzahlrelais (17) einen Abschaltbefehl erzeugt, wenn die Drehzahl der Welle (15, 16) einen vorgegebenen Drehzahlgrenzwert (n_{grenz}) überschreitet, mit folgenden Schritten:
a. Inaktivieren des dem Drehzahlrelais (17) zugeführten Drehzahlsignals;
b. Aktivieren eines Signalgenerators (28), der ein zu dem Drehzahlsignal äquivalentes Prüfsignal erzeugt, und Zuführen des Prüfsignals zu dem Signaleingang (25, 26, 27) des Drehzahlrelais (17);
c. Betreiben des Signalgenerators (28) mit einem jenseits des Drehzahlgrenzwerts (n_{grenz}) liegenden Prüfsignal;
d. Prüfen des Abschaltbefehls des Drehzahlrelais (17).

2. Verfahren nach Anspruch 1, **dadurch gekennzeichnet, dass** der Signalgenerator (28) mit einem Prüfsignal betrieben wird, mit dem der Drehzahlgrenzwert (n_{grenz}) nicht überschritten ist, und dass das Prüfsignal so verändert wird, dass der Drehzahlgrenzwert (n_{grenz}) überschritten wird.

3. Verfahren nach Anspruch 1 oder 2, **dadurch gekennzeichnet, dass** für den Signaleingang (25, 26, 27) des Drehzahlrelais (17) eine automatische Umschaltung zwischen dem Drehzahlsignal und dem Prüfsignal vorgesehen ist.

4. Verfahren nach einem der Ansprüche 1 bis 3, **dadurch gekennzeichnet, dass** das Prüfsignal an eine Mehrzahl von Signaleingängen des Drehzahlrelais (17) angelegt wird.

5. Verfahren nach einem der Ansprüche 1 bis 4, **dadurch gekennzeichnet, dass** die Windenergieanlage (10) eine Mehrzahl von Drehzahlrelais (171, 172, 173) umfasst und dass das Verfahren bei allen Drehzahlrelais (171, 172, 173) durchgeführt wird.

6. Verfahren nach einem der Ansprüche 1 bis 5, **dadurch gekennzeichnet, dass** die Windenergieanlage (10) eine Mehrzahl von Drehzahlsensoren (20, 21, 22) umfasst und dass die Drehzahlsignale der Drehzahlsensoren (20, 21, 22) miteinander verglichen werden.

7. Windenergieanlage mit folgenden Merkmalen:
a. ein Drehzahlsensor (20, 21, 22) zum Erfassen der Drehzahl einer Welle (15, 16);
b. ein Drehzahlrelais (17), das einen Signaleingang (25, 26, 27) aufweist, an dem ein Drehzahlsignal von dem Drehzahlsensor (20, 21, 22) anliegt, wobei das Drehzahlrelais (17) dazu ausgelegt ist, einen Abschaltbefehl zu erzeugen, sobald das Drehzahlsignal einen vorgegebenen Drehzahlgrenzwert (n_{grenz}) überschreitet;
**dadurch gekennzeichnet, dass** die Windenergieanlage die weiteren Merkmale aufweist.
c. ein Signalgenerator (28), der dazu ausgelegt ist, ein zu dem Drehzahlsignal äquivalentes Prüfsignal zu erzeugen
d. ein Umschaltmodul (30), um am Signaleingang (25, 26, 27) des Drehzahlrelais (17) zwischen dem Drehzahlsignals und dem Prüfsignal umzuschalten; und
e. ein Kontrollmodul (31), das den Signalgenerator (28) so steuert, dass er ein jenseits des Drehzahlgrenzwerts liegendes Prüfsignal erzeugt, das das Umschaltmodul (30) anweist, das Prüfsignal an den Signaleingang (25, 26, 27) zu legen, und das überprüft, ob das Drehzahlrelais (17) ein Abschaltbefehl erzeugt.

8. Windenergieanlage nach Anspruch 7, **dadurch gekennzeichnet, dass** das Drehzahlrelais (17) oder die Drehzahlrelais (171, 172, 173) eine Mehrzahl von Signaleingängen (25, 26, 27) aufweisen und dass das Umschaltmodul (30) dazu ausgelegt ist, an jedem der Signaleingänge (25, 26, 27) zwischen dem Drehzahlsignal und dem Prüfsignal umzuschalten.

9. Windenergieanlage nach Anspruch 7 oder 8, **dadurch gekennzeichnet, dass** sie ein Vergleichsmodul (32) aufweist, um die Drehzahlsignale einer Mehrzahl von Drehzahlsensoren (20 ,21, 22) zu vergleichen.

## Claims

1. A method for testing a rotational speed relay (17) of a wind energy installation (10), in which the wind energy installation (10) comprises a rotational speed sensor (20, 21, 22) for the rotational speed of a shaft (15, 16), in which the rotational speed sensor (20, 21, 22) outputs a rotational speed signal, in which the rotational speed signal is supplied to a signal input (25, 26, 27) of the rotational speed relay (17), and in which the rotational speed relay (17) generates a switch-off command if the rotational speed of the shaft (15, 16) exceeds a predefined rotational speed limit value (nₗᵢₘᵢₜ), having the following steps of:
a. deactivating the rotational speed signal supplied to the rotational speed relay (17);
b. activating a signal generator (28) which generates a test signal equivalent to the rotational speed signal and supplying the test signal to the signal input (25, 26, 27) of the rotational speed relay (17);
c. operating the signal generator (28) with a test signal beyond the rotational speed limit value (nₗᵢₘᵢₜ) ;
d. testing the switch-off command from the rotational speed relay (17).

2. The method as claimed in claim 1, **characterized in that** the signal generator (28) is operated with a test signal with which the rotational speed limit value (nₗᵢₘᵢₜ) is not exceeded, and **in that** the test signal is changed such that the rotational speed limit value (nₗᵢₘᵢₜ) is exceeded.

3. The method as claimed in claim 1 or 2, **characterized in that** automatic changeover between the rotational speed signal and the test signal is provided for the signal input (25, 26, 27) of the rotational speed relay (17).

4. The method as claimed in one of claims 1 to 3, **characterized in that** the test signal is applied to a plurality of signal inputs of the rotational speed relay (17) .

5. The method as claimed in one of claims 1 to 4, **characterized in that** the wind energy installation (10) comprises a plurality of rotational speed relays (171, 172, 173), and **in that** the method is carried out for all rotational speed relays (171, 172, 173) .

6. The method as claimed in one of claims 1 to 5, **characterized in that** the wind energy installation (10) comprises a plurality of rotational speed sensors (20, 21, 22), and **in that** the rotational speed signals from the rotational speed sensors (20, 21, 22) are compared with one another.

7. A wind energy installation having the following features:
a. a rotational speed sensor (20, 21, 22) for detecting the rotational speed of a shaft (15, 16);
b. a rotational speed relay (17) having a signal input (25, 26, 27) to which a rotational speed signal from the rotational speed sensor (20, 21, 22) is applied, the rotational speed relay (17) being designed to generate a switch-off command as soon as the rotational speed signal exceeds a predefined rotational speed limit value (nₗᵢₘᵢₜ) ; **characterized in that** the wind energy installation has the further features:
c. a signal generator (28) which is designed to generate a test signal equivalent to the rotational speed signal;
d. a changeover module (30) in order to change over between the rotational speed signal and the test signal at the signal input (25, 26, 27) of the rotational speed relay (17); and
e. a control module (31) which controls the signal generator (28) in such a manner that it generates a test signal beyond the rotational speed limit value, which instructs the changeover module (30) to apply the test signal to the signal input (25, 26, 27) and which checks whether the rotational speed relay (17) generates a switch-off command.

8. The wind energy installation as claimed in claim 7, **characterized in that** the rotational speed relay (17) or the rotational speed relays (171, 172, 173) has/have a plurality of signal inputs (25, 26, 27), and **in that** the changeover module (30) is designed to change over between the rotational speed signal and the test signal at each of the signal inputs (25, 26, 27).

9. The wind energy installation as claimed in claim 7 or 8, **characterized in that** it has a comparison module (32) in order to compare the rotational speed signals from a plurality of rotational speed sensors (20, 21, 22).

## Revendications

1. Procédé pour vérifier un relais de vitesse de rotation (17) d'une éolienne (10), dans lequel l'éolienne (10) comprend un capteur de vitesse de rotation (20, 21, 22) pour la vitesse de rotation d'un axe (15, 16), dans lequel le capteur de vitesse de rotation (20, 21, 22) émet un signal de vitesse de rotation, dans lequel le signal de vitesse de rotation est transmis à une entrée de signal (25, 26, 27) du relais de vitesse de rotation (17) et dans lequel le relais de vitesse de rotation (17) produit un ordre d'arrêt quand la vitesse de rotation de l'axe (15, 16) dépasse une limite de vitesse de rotation prédéfinie (n_{grenz}), comprenant les étapes suivantes :
a. inactivation du signal de vitesse de rotation transmis au relais de vitesse de rotation (17) ;
b. activation d'un générateur de signaux (28) qui produit un signal de vérification équivalent au signal de vitesse de rotation et transmission du signal de vérification à l'entrée de signal (25, 26, 27) du relais de vitesse de rotation (17) ;
c. utilisation du générateur de signaux (28) avec un signal de vérification situé au-delà de la limite de vitesse de rotation (n_{grenz}) ;
d. vérification de l'ordre d'arrêt du relais de vitesse de rotation (17).

2. Procédé selon la revendication 1, **caractérisé en ce que** le générateur de signaux (28) est utilisé avec un signal de vérification avec lequel la limite de vitesse de rotation (n_{grenz}) n'est pas dépassée et **en ce que** le signal de vérification est modifié de telle sorte que la limite de vitesse de rotation (n_{grenz}) est dépassée.

3. Procédé selon la revendication 1 ou 2, **caractérisé en ce qu'**il est prévu une commutation automatique entre le signal de vitesse de rotation et le signal de vérification pour l'entrée de signal (25, 26, 27) du relais de vitesse de rotation (17).

4. Procédé selon l'une des revendications 1 à 3, **caractérisé en ce que** le signal de vérification est appliqué à une pluralité d'entrées de signal du relais de vitesse de rotation (17).

5. Procédé selon l'une des revendications 1 à 4, **caractérisé en ce que** l'éolienne (10) comprend une pluralité de relais de vitesse de rotation (171, 172, 173) et **en ce que** le procédé est exécuté pour tous les relais de vitesse de rotation (171, 172, 173).

6. Procédé selon l'une des revendications 1 à 5, **caractérisé en ce que** l'éolienne (10) comprend une pluralité de capteurs de vitesse de rotation (20, 21, 22) et **en ce que** les signaux de vitesse de rotation des capteurs de vitesse de rotation (20, 21, 22) sont comparés les uns aux autres.

7. Éolienne ayant les caractéristiques suivantes :
a. un capteur de vitesse de rotation (20, 21, 22) pour déterminer la vitesse de rotation d'un axe (15, 16) ;
b. un relais de vitesse de rotation (17) qui présente une entrée de signal (25, 26, 27) à laquelle se trouve un signal de vitesse de rotation provenant du capteur de vitesse de rotation (20, 21, 22), le relais de vitesse de rotation (17) étant conçu pour produire un ordre d'arrêt dès que le signal de vitesse de rotation dépasse une limite de vitesse de rotation prédéfinie (n_{grenz}) ; **caractérisée en ce que** l'éolienne présente les caractéristiques supplémentaires suivantes :
c. un générateur de signaux (28) qui est conçu pour produire un signal de vérification équivalent au signal de vitesse de rotation ;
d. un module de commutation (30) pour effectuer une commutation entre le signal de vitesse de rotation et le signal de vérification à l'entrée de signal (25, 26, 27) du relais de vitesse de rotation (17) ; et
e. un module de contrôle (31) qui commande le générateur de signaux (28) de telle sorte qu'il produit un signal de vérification situé au-delà de la limite de vitesse de rotation qui indique au module de commutation (30) d'appliquer le signal de vérification à l'entrée de signal (25, 26, 27) et qui vérifie si le relais de vitesse de rotation (17) produit un ordre d'arrêt.

8. Éolienne selon la revendication 7, **caractérisée en ce que** le relais de vitesse de rotation (17) ou les relais de vitesse de rotation (171, 172, 173) présentent une pluralité d'entrées de signal (25, 26, 27) et **en ce que** le module de commutation (30) est conçu pour effectuer une commutation entre le signal de vitesse de rotation et le signal de vérification à chacune des entrées de signal (25, 26, 27).

9. Éolienne selon la revendication 7 ou 8, **caractérisée en ce qu'**elle présente un module de comparaison (32) pour comparer les signaux de vitesse de rotation d'une pluralité de capteurs de vitesse de rotation (20, 21, 22).
